# EUROPÄISCHE PATENTSCHRIFT

(11) **EP 4 365 807 B1**
(45) Veröffentlichungstag und Bekanntmachung des Hinweises auf die Patenterteilung: **04.12.2024**
(21) Anmeldenummer: 22205830.7
(22) Anmeldetag: 07.11.2022
(51) Int. Cl.: G06Q 30/0601, G05B 23/02

(54) **VERFAHREN FÜR EINE COMPUTER-GESTÜTZTE PRÜFUNG EINES INSTALLATIONSELEMENTS FÜR EINE INSTALLATIONSUMGEBUNG**
METHOD FOR COMPUTER-AIDED TESTING OF AN INSTALLATION ELEMENT FOR AN INSTALLATION ENVIRONMENT
PROCÉDÉ DE TEST ASSISTÉ PAR ORDINATEUR D'UN ÉLÉMENT D'INSTALLATION POUR UN ENVIRONNEMENT D'INSTALLATION

(43) Veröffentlichungstag der Anmeldung: 08.05.2024
(73) Patentinhaber: Murrelektronik GmbH, 71570 Oppenweiler (DE)
(72) Erfinder: Pfestorf, Sebastian, 71570 Oppenweiler (DE); Zeller, Paul, 74223 Flein (DE)
(74) Vertreter: Goebel, Sebastian

(56) Entgegenhaltungen:
- US-A1- 2020 143 606
- US-A1- 2021 133 377
- US-A1- 2022 270 149

## Beschreibung

### Technisches Gebiet

Die vorliegende Erfindung betrifft allgemein das Gebiet der Planung und Montage von Maschinen wie Automatisierungsanlagen und insbesondere eine computer-gestützte Installation von räumlich dezentral angeordneten, elektrischen Komponenten einer Maschine.

### Hintergrund

Die Komplexität und Vielfalt von Automatisierungsanlagen, die entwickelt, geplant, installiert, gewartet, und repariert werden müssen, wird zunehmend größer. In allen Phasen des Lebenszyklus einer solchen Anlage wie der Entwicklung/Planung, Produktion, Inbetriebsetzung, Betrieb und Wartung wird eine einfache und effiziente Unterstützung für einen Installateur oder Planer im Rahmen von Elektroinstallationsprojekten wichtiger.

Bei der Installation kann es vorkommen, dass Eigenschaften eines verwendeten Bauteils nicht den Anforderungen der Umgebung entsprechen. So kann es beispielsweise vorkommen, dass sich die Anforderungen vor Ort an einer Anlage von den bei der Planung angenommenen Anforderungen unterscheiden. Dann ist es von der Erfahrung und Expertise eines Installateurs abhängig, ob solche Abweichungen richtig eingeschätzt werden und wie eine Eignung des zu installierenden Bauteils für den weiteren Einsatz beurteilt wird. Damit ist diese Art der Prüfung mit einer großen Fehlerwahrscheinlichkeit bezüglich der Bewertung von Produkt- und Umgebungseigenschaften versehen, die später zu Ausfällen der Anlage führen kann.

Es ist daher eine Aufgabe der vorliegenden Erfindung, ein computer-gestütztes Verfahren und System bereitzustellen, um eine Installation von Bauteilen und elektrischen Komponenten zu ermöglichen und dabei die voranstehend beschriebenen Nachteile zumindest teilweise zu beheben.

Die Veröffentlichungen US 2022/270149 A1, US 2021/133377 A1 und US 2020/143606 A1 offenbaren gattungsgemäße Verfahren.

### Zusammenfassung der Erfindung

Die voranstehende Aufgabe wird gelöst durch ein Verfahren, ein Computerprogramm sowie eine Vorrichtung zur Datenverarbeitung gemäß den unabhängigen Ansprüchen. Weitere Merkmale und Details der Erfindung ergeben sich aus den jeweiligen Unteransprüchen, der Beschreibung und den Zeichnungen.

Gegenstand der Erfindung ist insbesondere ein Verfahren für eine computer-gestützte Prüfung eines Installationselements, insbesondere eines Bauteils und/oder Kabels und/oder Steckverbinders, für eine Installationsumgebung, vorzugsweise bei einer Installation von räumlich dezentral angeordneten, elektrischen Komponenten einer Maschine, insbesondere einer Anlage.

Die Maschine kann als wenigstens eine der nachfolgend genannten Maschinen ausgebildet sein:
- Eine Automatisierungsanlage,
- Eine Produktionsanlage,
- Eine Logistikanlage,
- Eine Produktionsstraße,
- Ein Bearbeitungszentrum,
- Ein Industrieroboter,
- Eine Fertigungsanlage,
- Ein Aggregat,
- Ein Elektrogerät.

Insbesondere kann die Maschine dabei als eine Maschine mit modularem Charakter oder auch als mobile oder bewegliche Maschine ausgebildet sein, bei welcher einzelne Teile der Maschine modular gemäß einer Installationsvorgabe installiert werden. Diese Installation erfolgt zumindest teilweise manuell durch einen Benutzer wie einem Werker.

Die elektrischen Komponenten können Verbindungsmodule sein, welche eine dezentrale und modulare Verbindung von Installationselementen ermöglichen. Dezentral kann sich dabei darauf beziehen, dass die Verbindungsmodule zumindest teilweise einen zentralen Schaltschrank ersetzen, indem die Verbindungsmodule zwar jeweils nur einen Teil der Verbindungen für die Maschine bereitstellen, diese Verbindungen aber dezentral im Feld ermöglichen. Bei einer zentralen Topologie, also bspw. einem zentralisierten Schaltschrankkonzept, wird insbesondere von einer Punkt-zu-Punkt-Verbindung gesprochen, d.h. der Startpunkt, die Verbindung und der Endpunkt sind klar definiert. Im Gegensatz dazu ist es bei dezentralen Anwendungen möglich, bzw. kann sogar oftmals notwendig sein, zwischen dem Startpunkt und dem Endpunkt mehrere Komponenten anzuordnen oder zu verbinden. In diesem Fall kann z. B. von einer Modul-Modul oder Modul-Hub-Punkt-Verbindung gesprochen werden. Grundsätzlich können bei einer Maschine bspw. die folgenden Komponenten vorgesehen sein: Geräte wie Aktoren und/oder Sensoren, die Verbindungsmodule, Installationselemente, bspw. zur Verkabelung.

Das erfindungsgemäße Verfahren umfasst die nachfolgenden Schritte, welche vorzugsweise nacheinander oder in beliebiger Reihenfolge ausgeführt werden, wobei die Schritte auch automatisiert und/oder wiederholt ausgeführt werden können:
- Prüfen einer Eignung des Installationselements für eine Installation in der Installationsumgebung, vorzugsweise auf Basis einer Kompatibilitätsbeurteilung mindestens einer Eigenschaft des Installationselements in Relation zu mindestens einer Eigenschaft der Installationsumgebung, insbesondere einer Temperatur und/oder Luftfeuchtigkeit und/oder elektrischen Spannung und/oder Beschleunigung;
- Generieren wenigstens einer Installationsinformation auf Basis eines Ergebnisses des Prüfens zur Unterstützung eines Benutzers bei der Installation; und
- Initiieren einer Ausgabe der generierten wenigstens einen Installationsinformation für den Benutzer.

Damit ermöglicht das Verfahren eine einfachere, schnellere und fehlerfreie Installation und kann einen Benutzer bei einer Installation der Maschine wesentlich unterstützen und den Prozess qualitativ verbessern. Des Weiteren kann eine signifikante Reduzierung zeitlich sehr aufwendiger Überprüfungen durch qualifiziertes Fachpersonal ermöglicht werden. Ferner hat das Verfahren den Vorteil, dass eine effizientere und effektive Nutzung von verfügbaren Installationselementen wie beispielsweise Kabeln und/oder Bauteilen bei der Installation gewährleistet ist. Zudem wird in vorteilhafter Weise eine deutliche Verbesserung der Lebenszeit der einzelnen Installationselemente ermöglicht. Ferner vereinfacht das Verfahren deutlich den flexibleren Einsatz von Arbeitskräften, da keine hohen Anforderungen an die fachliche Qualifikation bei der Durchführung der Installation erforderlich sind.

Es kann auf diese Weise ein Unterstützungssystem zur Installation, insbesondere zur Verkabelung, während der Installation hinsichtlich einer Eignung eines Installationselements für die beabsichtigte Verwendung bereitgestellt werden, bei welchem eine Datenverarbeitungsvorrichtung die Verfahrensschritte automatisiert ausführen kann. Die Datenverarbeitungsvorrichtung, insbesondere eine erfindungsgemäße Vorrichtung zur Datenverarbeitung, kann dabei vorteilhafterweise mit einzelnen Komponenten kommunizieren und damit die Ausgabe der Installationsinformation ermöglichen. Hierzu kann die Datenverarbeitungsvorrichtung wenigstens eine Schnittstelle für die Kommunikation aufweisen.

Ein Benutzer kann bspw. ein Installateur und/oder Anlagenmechaniker und/oder Elektriker und/oder Werker und/oder Planer und/oder mechanischer Konstrukteur oder Entwickler und/oder elektrischer Konstrukteur oder Entwickler und/oder SPS-Programmierer und/oder Inbetriebnehmer und/oder Instandhalter und/oder Maschinenführer sein. Es ist möglich, dass der Benutzer das erfindungsgemäße Verfahren dadurch verwendet, dass das Verfahren über einen Computer für den Benutzer bereitgestellt wird. Hierzu kann ein Computerprogramm zumindest teilweise durch den Computer und/oder einen weiteren Computer ausgeführt werden, um die erfindungsgemäßen Verfahrensschritte durchzuführen.

Für die Installation der Maschine können mehrere Installationselemente vorgesehen sein. Diesen Installationselementen kann jeweils ein Identifikator zugeordnet sein, durch welchen die Installationselemente eindeutig identifiziert werden können. Der Identifikator kann entsprechend eine Information sein, welche bspw. digital verarbeitet werden kann. Das jeweilige Installationselement kann den Identifikator dadurch aufweisen, dass ein physisches Identifikationsmittel am Installationselement vorgesehen und/oder angebracht ist. Die Installationselemente können bspw. Kabel oder Bauteile sein, welche ein funktionaler Teil der Maschine sind. Der Identifikator umfasst vorteilhafterweise eine eindeutige und insbesondere eineindeutige Kennung. Damit ist es möglich, das Installationselement anhand des Identifikators eindeutig im Zusammenhang mit der Maschine und/oder auch weiteren Maschinen und/oder der Installation der Maschine zu identifizieren. Dem Identifikator können eine oder mehrere Informationen über das Installationselement zugewiesen werden. Die wenigstens eine Information kann wenigstens eine der nachfolgenden Informationen umfassen: wenigstens eine Zustandsinformation, die ausgegebene Installationsinformation, eine Kennung der identifizierten Komponente, wenigstens eine der nachfolgend noch näher beschriebenen Dokumentationsspezifikationen wie Bauteiltyp, Maschinentyp, Anlagentyp, Benutzer, Anschlussstellenbezeichnung, Zeitstempel Datum und Uhrzeit, Installationsdauer, Adresse in einem Bussystem, Betriebsmittelkennzeichnung, Kabellänge, Portbelegung, Eigenschaften des offenen Kabels, Kabellänge, Temperatur, Luftfeuchtigkeit, aktueller Projektstand bei der Montage, Planabweichung und Grund. Eine digitale Hinterlegung der wenigstens einen Information zugeordnet zu dem Identifikator ermöglicht es somit, einen digitalen Zwilling des Installationselements zu schaffen.

Vorzugsweise kann das Installationselement ein Kabel und/oder ein Bauteil umfassen, wobei das Kabel mindestens oder genau einen Steckverbinder aufweisen kann, und bevorzugt einseitig konfektioniert sein kann, d.h. einseitig einen weiblichen oder männlichen Stecker und an der anderen Seite ein offenes Ende aufweist. Alternativ kann das Kabel auch zweiseitig konfektioniert sein, d.h. an jeder Seite weist das Kabel einen weiblichen oder männlichen Stecker auf.

Es kann ferner möglich sein, dass die wenigstens eine Installationsinformation eine Installationsanweisung zur Unterstützung des Benutzers bei der Installation umfasst, wobei vorzugsweise das Initiieren der Ausgabe zumindest einen der nachfolgenden Schritte umfasst:
- Initiieren einer Ausgabe der Installationsanweisung als eine Angabe einer Anschlussstelle einer elektrischen Komponente für einen Anschluss des Installationselements und/oder einer Angabe zur Eignung des Installationselements, vorzugsweise als Angabe für den Benutzer, dass das Installationselement für die Verwendung in der Installationsumgebung geeignet ist;
- Initiieren einer visuellen Ausgabe der Installationsanweisung, vorzugsweise durch eine grafische Benutzeroberfläche und/oder mittels Erweiterter Realität und/oder durch einen Signalgeber der elektrischen Komponente;
- Initiieren einer akustischen Ausgabe, insbesondere einer Sprachausgabe, der Installationsanweisung.

Dies ermöglicht eine unmittelbare Information des Benutzers durch die Installationsanweisung, ob das Installationselement für die Verwendung in der Installationsumgebung geeignet ist und in welcher Weise eine Installation erfolgen soll. Die Benutzeroberfläche kann eine grafische Benutzeroberfläche sein, welche auf einem Bildschirm vorzugsweise eines Computers dargestellt wird. Der Computer kann bspw. ein tragbarer Computer wie ein Laptop oder Tablet sein.

Die Anzeige mittels Erweiterter Realität (engl. Augmented Reality) kann bspw. dadurch erfolgen, dass eine VR (Virtual Reality) Brille durch einen Benutzer verwendet wird, um zusätzliche Informationen anzuzeigen, und/oder dass die Umgebung des Benutzers durch eine Kamera aufzeichnet und das Kamerabild verarbeitet wird, um zusätzliche Informationen in das Kamerabild einzubringen. Die zusätzlichen Informationen umfassen z. B. die Hervorhebung der Anschlussstelle, wenn in dem Kamerabild die physische Anschlussstelle der Komponente zu sehen ist.

Ferner kann auch eine akustische Ausgabe vorgesehen sein, welche z. B. eine Ansteuerung eines Lautsprechers umfasst. Die akustische Ausgabe kann bspw. eine Sprachausgabe sein, durch welche die Anschlussbezeichnung der Anschlussstelle gesprochen wird.

Ferner kann es im Rahmen der Erfindung vorgesehen sein, dass bei dem Initiieren der Ausgabe wenigstens einer der nachfolgenden Schritte durchgeführt wird, wenn anhand des Ergebnisses des Prüfens die Eignung des Installationselements für die Installation in der Installationsumgebung als unzureichend festgestellt wird:
- Initiieren einer Ausgabe eines Warnhinweises und/oder einer Fehlermeldung, vorzugsweise des Warnhinweises und/oder der Fehlermeldung, dass das Installationselement nicht für die Verwendung in der Installationsumgebung geeignet ist und eine Funktionalität des Installationselements signifikant beeinträchtigt ist;
- Initiieren einer Korrektur der Verbindung in der Installationsvorgabe;
- Initiieren einer Ausgabe einer Installationsanweisung und/oder einer Handlungsempfehlung, vorzugsweise mit einer Angabe eines anderen Installationselements mit einer höheren Eignung als das geprüfte Installationselement für die Installation in der Installationsumgebung.

Dies hat den Vorteil, dass eine unmittelbare und schnellere Information für den Benutzer während der Installation bereitgestellt wird, wenn das bei der Prüfung festgestellt wird, dass das Installationselement für die Installationsumgebung nicht geeignet ist. Ferner ermöglicht dies, dass der Benutzer schneller seine Aktivität korrigieren kann oder besser in die Lage versetzt wird, mögliche Alternativen zu erkennen.

Es kann ferner möglich sein, dass das Verfahren den nachfolgenden weiteren Schritt umfasst:
- Automatisches Dokumentieren der Eignung des Installationselements in Abhängigkeit des Ergebnisses des Prüfens.

Dies hat den Vorteil, dass für eine spätere Kontrolle eine einfachere Nachweisbarkeit gewährleistet ist. Ferner reduziert dies vorteilhafterweise signifikant den Zeitaufwand und die Fehlerhaftigkeit der Eingabe für den Benutzer, da ein manuelles Dokumentieren entfällt.

Optional kann es vorgesehen sein, dass das Verfahren den nachfolgenden weiteren Schritt umfasst:
- Bereitstellen von Installationsdaten des Installationselements, insbesondere eines Kabels und/oder Steckverbinders, wobei die Installationsdaten Planungsdaten für Eigenschaften des Installationselements umfassen.

Des Weiteren kann vorgesehen sein, dass das Verfahren den nachfolgenden weiteren Schritt umfasst:
- Bereitstellen von Installationsdaten der Installationsumgebung, wobei die Installationsdaten Planungsdaten für Eigenschaften der Installationsumgebung umfassen.

Dies hat den Vorteil, dass das Verfahren eine einfachere und fehlerfreie Zuordnung von Eigenschaften eines zu installierenden Installationselements und/oder Eigenschaften einer tatsächlichen Installationsumgebung zu den entsprechenden Planungsdaten ermöglicht und kann damit einen Benutzer bei der Installation wesentlich unterstützen und den Prozess vereinfachen und beschleunigen. Ferner ermöglicht dies, dass durch die bereitgestellten Planungsdaten potenzielle Probleme schneller identifiziert werden, um spätere Störungen beim Betrieb einer Maschine zu vermeiden.

Ein weiterer Vorteil im Rahmen der Erfindung ist erzielbar, wenn die mindestens eine Eigenschaft des Installationselements zumindest eine der folgenden umfasst:
- ein zulässiger Temperaturbereich, für welchen das Installationselement geeignet ist;
- einen Bereich einer Luftfeuchtigkeit, für welchen das Installationselement geeignet ist;
- einen elektrische Nennspannung, für welche das Installationselement geeignet ist;
- einen minimalen Biegeradius, für welchen das Installationselement geeignet ist;
- eine minimale und/oder maximale mechanische Belastung, für welche das Installationselement geeignet ist;
- eine zulässige Beschleunigung, für welche das Installationselement (10) geeignet ist;
- eine minimale und/oder maximale Anzahl an Adern innerhalb des Steckverbinders und/oder Kabels;
- eine Kodierung des Steckverbinders als Signalleitung A-, B-, C-, D-, oder X-Kodiert und/oder als Powerleitung A-, K-, L und/oder als Datenleitung A-, B-, D-, X-, und Y-Kodiert und/oder mit LED und/oder Kodierung als geschirmter oder ungeschirmter Steckverbinder und/oder einer Hybridleitung, insbesondere als Kombination aus den vorgenannten Leitungen;
- einen spezifischen Kabelabgang, vorzugsweise eines Steckers für einen Bereich von 0° - bis 90°, bevorzugt 45° bis 60°, für welchen das Installationselement geeignet ist;
- einen spezifischen Anschluss auf den jeweiligen Seiten, für welche ein Installationselement geeignet ist, insbesondere als M8-, M12-, M23-, RJ45-, 7/8 (sieben-achtel)-, MQ15-, MSUD- (Ventilstecker), Deutschstecker- oder RJ45PP-Anschluss;
- einen spezifischen Steckverbindertyp, für welche das Installationselement geeignet ist, insbesondere ein Steckverbindertyp vom Typ Buchse-Buchse, Buchse-Stecker, Stecker-Buchse oder Stecker-Stecker, H-, T- und Y- Stücke und Verteiler;
- eine spezifische Anwendung, für welche das Installationselement geeignet ist, insbesondere als AS-Interface, als Ethernet-, als Motoren-, als Feldbus- Anwendung oder Sensor-/Aktor-Leitung;
- eine entsprechende Bauform des Installationselements in Abhängigkeit der Umgebung, für welche das Installationselement geeignet ist;
- eine Sicherheits- und/ oder Redundanzanforderung, für welche das Installationselement geeignet ist.

Nach einer weiteren Möglichkeit kann vorgesehen sein, dass die mindestens eine Eigenschaft der Installationsumgebung zumindest eine der folgenden umfasst:
- einen Temperaturbereich, welcher in der Installationsumgebung als Lufttemperatur vorgesehen ist;
- eine Luftfeuchtigkeit, welche in der Installationsumgebung vorgesehen ist;
- eine Nässe, welche in der Installationsumgebung vorgesehen ist;
- eine elektrische Spannung, welche als Betriebsspannung für das Installationselement vorgesehen ist;
- eine Chemikalienresistenz, welche in der Installationsumgebung vorgesehen ist;
- einen Luftdruck, welcher in der Installationsumgebung vorgesehen ist;
- eine UV-Belastung, welche in der Installationsumgebung vorgesehen ist;
- eine bakterielle Belastung, welche in der Installationsumgebung vorgesehen ist;
- eine biologische Belastung (z.B. tierische Substanzen etc.), welche in der Installationsumgebung vorgesehen ist;
- eine Vibration, welche in der Installationsumgebung vorgesehen ist;
- eine Geräuschbelastung, d. h. Umgebungsgeräusche, welche in der Installationsumgebung vorgesehen ist;
- ein Körperschall, welche in der Installationsumgebung vorgesehen ist;
- eine entsprechende Bauform des Installationselements in Abhängigkeit der Einsatzbranche, für welche das Installationselement geeignet ist.

Dies ermöglicht es, dass eine genauere Ermittlung eines Problems bei der Installation gewährleistet ist. Des Weiteren hat dies den Vorteil, dass dies eine effektivere Handlungsempfehlung bezüglich eines besser geeigneten Installationselements oder eine effektivere Beurteilung der Eignung des Installationselements trotz Abweichung von einer gemessenen Eigenschaft gewährleistet.

Es ist ferner denkbar, dass das Prüfen der Eignung des Installationselements für die Installation in der Installationsumgebung die nachfolgenden Schritte umfasst:
- Ermitteln der mindestens einen Eigenschaft des Installationselements, bevorzugt aus einer Datenbank und/oder aus einem Datenspeicher, wobei die mindestens eine Eigenschaft jeweils eine Anforderung an einen Parameter der Installationsumgebung definiert und/oder einen technischen Parameter des Installationselements angibt;
- Ermitteln der mindestens einen Eigenschaft der Installationsumgebung, bevorzugt durch eine Messung und/oder aus einer Datenbank und/oder aus einem Datenspeicher, wobei die mindestens eine Eigenschaft jeweils eine Anforderung an den technischen Parameter des Installationselements definiert und/oder den Parameter der Installationsumgebung angibt;
- Durchführen der Kompatibilitätsbeurteilung durch eine Überprüfung der mindestens einen Anforderung, um bei einer Erfüllung die Eignung des Installationselements für die Installation in der Installationsumgebung als ausreichend und andernfalls als unzureichend festzustellen.

Dies ermöglicht es, dass eine genauere Prüfung der Eignung bei der Installation gewährleistet ist. Des Weiteren hat dies den Vorteil, dass dies eine effektivere Handlungsempfehlung bezüglich eines besser geeigneten Installationselements oder eine effektivere Beurteilung der Eignung des Installationselements trotz Abweichung von einer gemessenen Eigenschaft gewährleistet.

Weiter ist im Rahmen der Erfindung denkbar, dass das Verfahren den nachfolgenden weiteren Schritt umfasst:
- Empfangen eines Identifikators des Installationselements, vorzugsweise von einem Lesegerät, bevorzugt durch einen Scanner, um die Eignung des Installationselements für die Installationsumgebung zu überprüfen;
- Auslesen von mindestens einer Eigenschaft des Installationselements aus einer Datenbank auf Basis des empfangenen Identifikators.

Dies ermöglicht es, eine einfachere, schnellere und fehlerfreie Zuordnung von Installationselementen und dessen Eigenschaften bei der Prüfung der Eignung für die Installationsumgebung zu gewährleisten.

Erfindungsgemäß ist vorgesehen, dass das Verfahren bei dem Prüfen der Eignung den nachfolgenden weiteren Schritt umfasst:
- Überprüfen der Einhaltung mindestens eines Referenz- und/oder Grenzwertes für die mindestens eine Eigenschaft des Installationselements, insbesondere Temperatur und/oder Luftfeuchtigkeit und/oder elektrischer Spannung.

Dies hat den Vorteil, dass eine schnellere Bereitstellung eines Ergebnisses des Prüfens gewährleistet wird. Ferner ermöglicht dies eine effizientere und gezieltere Überprüfung der Eignung bezüglich einzelner Eigenschaften, um eine bessere und konkretere Beurteilung und Handlungsempfehlung zu gewährleisten.

Es ist ferner denkbar, dass das Verfahren die nachfolgenden Schritte umfasst, wenn eine Abweichung der mindestens einen Eigenschaft des Installationselements von dem mindestens einen Referenz- und/oder Grenzwert festgestellt wird:
- Simulieren einer Auswirkung der Abweichung, um in Abhängigkeit von der Auswirkung die Eignung des Installationselements für die Installation in der Installationsumgebung festzustellen;
- Spezifizieren eines weiteren Installationselements, das für die Verwendung in der Installationsumgebung eine höhere Eignung aufweist und/oder eine Funktionalität der Maschine gewährleistet, falls die Eignung als unzureichend festgestellt wird; und
- Generieren einer Ausgabe der Installationsinformation in Abhängigkeit eines Ergebnisses des Simulierens, wobei vorzugsweise eine Liste von geeigneten Installationselementen für die Installationsumgebung ausgegeben wird.

Dies ermöglicht eine Überprüfung von Abweichungen in Form geeigneter Installationselemente. Diese Optimierung kann dadurch erreicht werden, dass die Auswirkungen von Abweichungen simuliert und ausgegeben werden. Durch das Simulieren ist es vorteilhafterweise möglich, festzustellen, ob es sich bei dem spezifizierten Installationselement um eine Alternative handelt, die eine höhere Eignung für die Installationsumgebung aufweist. Auch kann durch das Simulieren festgestellt werden, ob es sich bei dem spezifizierten Installationselement um eine Alternative handelt, die in der Installationsumgebung alle erforderlichen Eigenschaften erfüllt.

Erfindungsgemäß ist vorgesehen, dass das Verfahren die nachfolgenden Schritte umfasst, wenn eine Abweichung der mindestens einen Eigenschaft des Installationselements von dem mindestens einen Referenz- und/oder Grenzwert festgestellt wird:
- Simulieren einer negativen Auswirkung der Abweichung, um ein weiteres Installationselement zu spezifizieren, durch dessen Einsatz die negative Auswirkung neutralisiert wird;
- Generieren einer Ausgabe der Installationsinformation in Abhängigkeit eines Ergebnisses des Simulierens, wobei vorzugsweise eine Liste von geeigneten Installationselementen für die Installationsumgebung ausgegeben wird.

Dies ermöglicht eine Überprüfung von Abweichungen in Form geeigneter weiterer Installationselemente. Durch das Simulieren der negativen Auswirkung ist es vorteilhafterweise möglich, festzustellen, ob das weitere spezifizierte Installationselement bei einer Installation die negative Auswirkung der Abweichung beseitigen kann.

Ebenfalls Gegenstand der Erfindung ist eine Vorrichtung zur Datenverarbeitung mit Mitteln zur Durchführung des Verfahrens nach einem der vorhergehenden Ansprüche. Damit bringt die erfindungsgemäße Vorrichtung die gleichen Vorteile mit sich, wie sie ausführlich mit Bezug auf ein erfindungsgemäßes Verfahren beschrieben worden sind. Die Vorrichtung kann Teil zumindest oder genau einer der wenigstens einen Maschine sein.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Als der Computer kann eine Datenverarbeitungsvorrichtung, bspw. die erfindungsgemäße Vorrichtung, vorgesehen sein, welche das Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls ist es denkbar, dass der Computer zumindest einen integrierten Schaltkreis wie einen Mikroprozessor oder eine Anwendungsspezifische integrierte Schaltung (ASIC) oder ein Anwendungsspezifisches Standardprodukt (ASSP) oder einen digitalen Signalprozessor (DSP) oder einen Field Programmable Gate Array (FPGA) oder dergleichen umfasst. Der Computer kann ferner wenigstens eine Schnittstelle zum Datenaustausch, z. B. eine Ethernet-Schnittstelle oder eine Schnittstelle für LAN (Local Area Network) oder WLAN (Wireless Local Area Network) oder System-on-a-Chip (SoC) oder eine andere Funkschnittstelle wie Bluetooth oder Nahfeldkommunikation (NFC) aufweisen. Ferner kann der Computer als ein oder mehrere Steuergeräte, d. h. auch als ein System aus Steuergeräten, ausgeführt sein. Der Computer kann bspw. auch in einer Cloud und/oder als ein Server vorgesehen sein, um über die Schnittstelle die Datenverarbeitung für eine lokale Anwendung zur Verfügung zu stellen. Auch ist es möglich, dass der Computer als ein mobiles Gerät, wie ein Smartphone, ausgeführt ist.

Ebenfalls Gegenstand der Erfindung kann ein computerlesbares Speichermedium sein, welches das erfindungsgemäße Computerprogramm umfasst. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein.

### Kurzbeschreibung der Zeichnungen

Zum besseren Verständnis der Offenbarung wird auf die folgenden Zeichnungen verwiesen:
Fig. 1: Eine zentrale Verschaltung bei einer Maschine mittels eines Schaltschranks.
Fig. 2: Eine dezentrale Verschaltung gemäß Ausführungsbeispielen der Erfindung.
Fig. 3 Eine schematische Darstellung von Teilen eines Systems gemäß Ausführungsbeispielen der Erfindung.
Fig. 4 Eine schematische Darstellung von Einzelheiten eines Verfahrens gemäß Ausführungsbeispielen der Erfindung.
Fig. 5 Eine schematische Darstellung von Schritten eines Verfahrens gemäß Ausführungsbeispielen der Erfindung.

### Beschreibung der Ausführungsbeispiele

Das Planen, Installieren und Einrichten von Maschinen sowie elektronischer Automatisierungstechnik ist eine komplexe Aufgabe. Dies gilt für zentralisierte Schaltschrank-Systeme ebenso, wie für dezentralisierte Systeme, in denen Steuerungsmodule direkt an den Anlagen angebracht werden. Die entsprechenden Prozesse werden von unterschiedlichen Personen, wie Anlagen-Planer, Elektro-Planer, Installateur, Anlagenprogrammierer etc. durchgeführt. Eine Besonderheit bei dezentralen Systemen ist die Verteilung der Module an verschiedenen Stellen einer Maschine im Vergleich zu den zentralisierten Schaltschrank-Systemen. Gerade bei größeren Maschinen kann eine simultane, das heißt zeitgleich parallel durch mehrere Benutzer ausgeführte Installation aus zeitlichen und logistischen Gründen vorteilhaft sein. Um einen reibungslosen Installationsprozess zu ermöglichen, soll der Arbeitsstand automatisch, benutzerindividuell und in Echtzeit digital dokumentiert werden. Über den ganzen Anlagen-Lebenszyklus ist es aus unterschiedlichen Gründen (wie z.B. Wartungsplanung, Systemdiagnosen) wichtig, über eine vollständige Dokumentation, aller relevanten Informationen zu verfügen, auch in Bezug auf eine Dokumentation hinsichtlich einer Eignung der installierten Komponenten und/oder Bauteilen.

Bei der Installation kann es vorkommen, dass die tatsächliche Situation vor Ort von der vorgesehenen Planung abweicht. Somit ursprünglich vorgesehene Bauteile nun nicht mehr zu den tatsächlichen Umgebungsbedingungen passen. In solchen Fällen kann ein Verfahren und System unterstützen, welches automatisch während der Installation die Produkteigenschaften mit den Umgebungseigenschaften abgleicht und auf Kompatibilität überprüft. Im Falle einer fehlenden Kompatibilität wird ein Benutzer durch erzeugte und ausgegebene Hinweise oder Alternativvorschläge des Systems unterstützt.

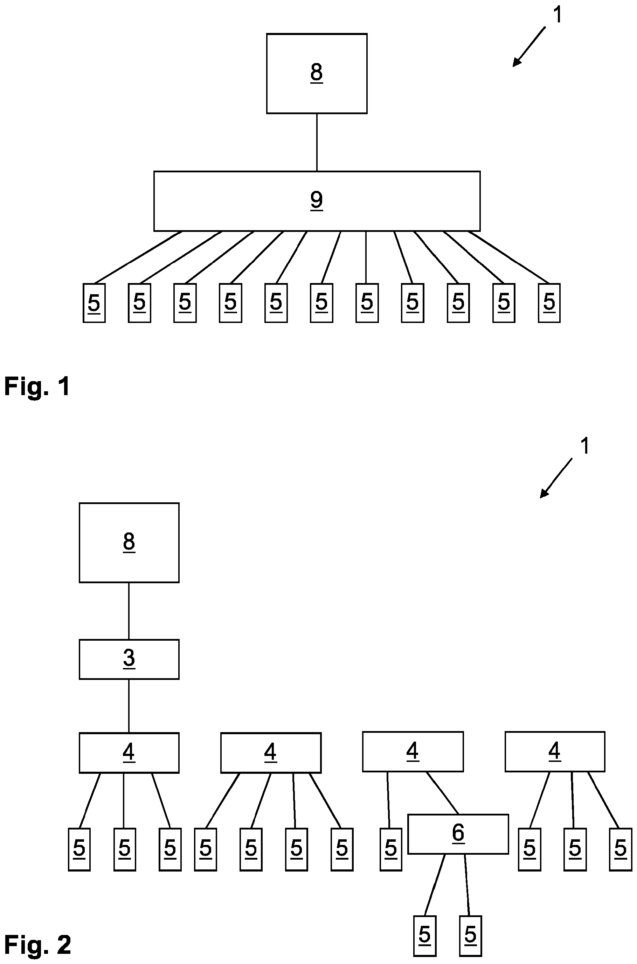

In Fig. 1 ist schematisch eine zentrale Verschaltung mittels eines Schaltschranks 9 dargestellt, um diese einer dezentralen Verschaltung mittels räumlich dezentral angeordneten, elektrischen Komponenten 4 einer Maschine 1 in Fig. 2 gegenüberzustellen. Anstelle einer Verbindung sämtlicher Geräte 5 wie Sensoren und Aktoren unmittelbar mit dem Schaltschrank 9 wie in Fig. 1 dargestellt, können bei der dezentralen Verschaltung in Fig. 2 mehrere Komponenten 4, also insbesondere Verbindungsmodule, eingesetzt werden. Diese ermöglichen, wie der Schaltschrank 9, eine Kopplung der Geräte 5 mit einer Steuerungsvorrichtung 8 wie einer SPS. Allerdings können die Verbindungsmodule 4 dezentral und verteilt in der Nähe zu den Geräte 5 vorgesehen sein. Die Verbindungsmodule 4 verschalten somit jeweils die Geräte 5 nur teilweise, wobei die Verbindungsmodule 4 zusammen oder beispielsweise ein und/oder mehrere Verbindungsmodule 4 über jeweils einen und/oder mehrere Hubs 6 die gesamte Verschaltung vornehmen. Um die Konfiguration und/oder Ansteuerung der Verbindungsmodule 4 zentral zu ermöglichen, kann ein Mastermodul 3 mehreren der einzelnen Verbindungsmodulen 4 vorgeschaltet sein. Ebenfalls ist es möglich, dass eine weitere Untergliederung der Verschaltung mittels wenigstens eines Hubs 6 erfolgt.

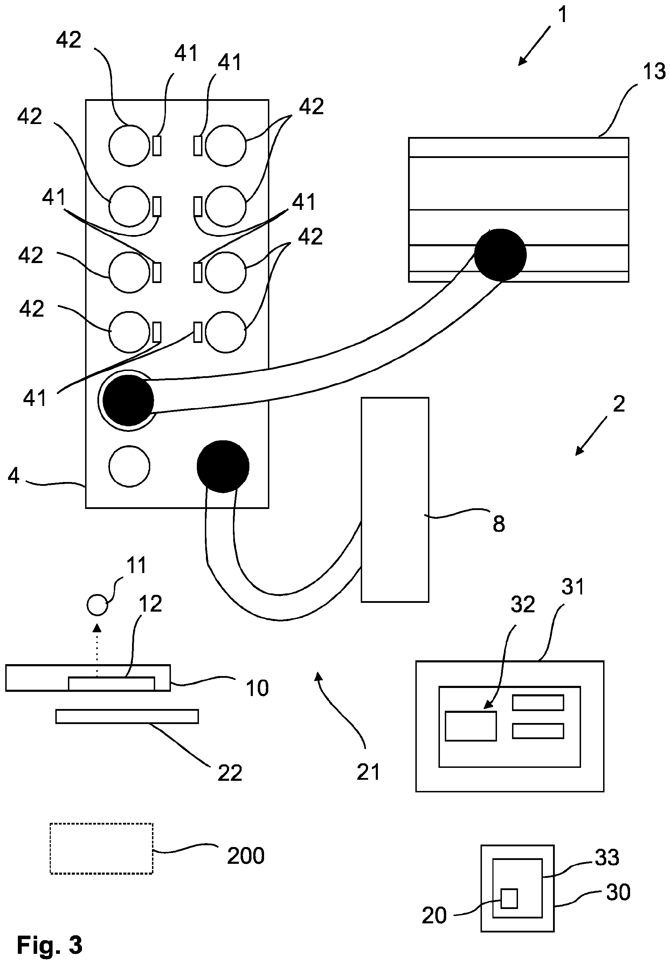

In Fig. 3 sind Teile eines Systems 2 gemäß Ausführungsbeispielen der Erfindung dargestellt, welches für eine computer-gestützte Prüfung eines Installationselements für eine Installationsumgebung bei der Installation von räumlich dezentral angeordneten elektrischen Komponenten 4 einer Maschine 1 vorgesehen sein kann. Das System 2 kann eine Detektionsvorrichtung 22, insbesondere einen Scanner 22 oder eine Kamera 22, für eine Bereitstellung eines Identifikators 11 eines Installationselements 10, vorzugsweise eines Kabels 10 oder eines Bauteils 10, umfassen. Ferner kann das System 2 wenigstens eine elektrische Komponente 4, vorzugsweise in der Form eines Verbindungsmoduls 4 zur Verbindung mit dem Installationselement 10 und weiteren Installationselementen 10, aufweisen. Ebenfalls kann eine Vorrichtung 30 zur Datenverarbeitung Teil des Systems 2 sein, wobei diese Datenverarbeitungsvorrichtung 30 Mittel zur Ausführung der Schritte eines Verfahren 100 gemäß Ausführungsbeispielen der Erfindung umfassen kann. Der Identifikator 11 kann in einem dem Installationselement 10 zugeordneten, insbesondere an diesem angeordneten, maschinenlesbaren Code 12 kodiert sein, wobei der maschinenlesbare Code 12 mittels der Detektionsvorrichtung 22 maschinenlesbar ausgeführt ist. Damit ist es für einen Benutzer möglich, mittels der Detektionsvorrichtung 22 den Code 12 einzuscannen und somit den Identifikator 11 an die Datenverarbeitungsvorrichtung 30 zu übertragen. Ferner können die Komponenten 4 und wenigstens ein Computer 30, 31 und/oder eine Steuerungsvorrichtung 8 über ein Bussystem 21 jeweils zur bidirektionalen Kommunikation miteinander verbunden sein, wobei die bidirektionale Kommunikation auf Basis eines Kommunikationsprotokolls für ein Feldbussystem vorgesehen sein kann, insbesondere auf Basis eines ProfiNet-, Ethernet/IP- oder 802.3-Standards, und/oder die bidirektionale Kommunikation kabelgebunden über ein Bussystem 21 oder kabellos mittels Bluetooth oder WLAN, auf Basis eines Standards gemäß IEEE 802.11 oder auf Basis eines Mobilfunk-Telekommunikationsstandards vorgesehen sein kann. Um einen Betrieb der Komponente 4 zu ermöglichen, kann die Komponente 4 ferner mit einer Energieversorgung 13 verbunden sein.

Ferner ist ein Computerprogramm 20 dargestellt, welches Befehle umfasst, die bei der Ausführung des Programms durch einen Computer 30 diesen veranlassen, die Schritte des Verfahrens 100 gemäß Ausführungsbeispielen der Erfindung auszuführen.

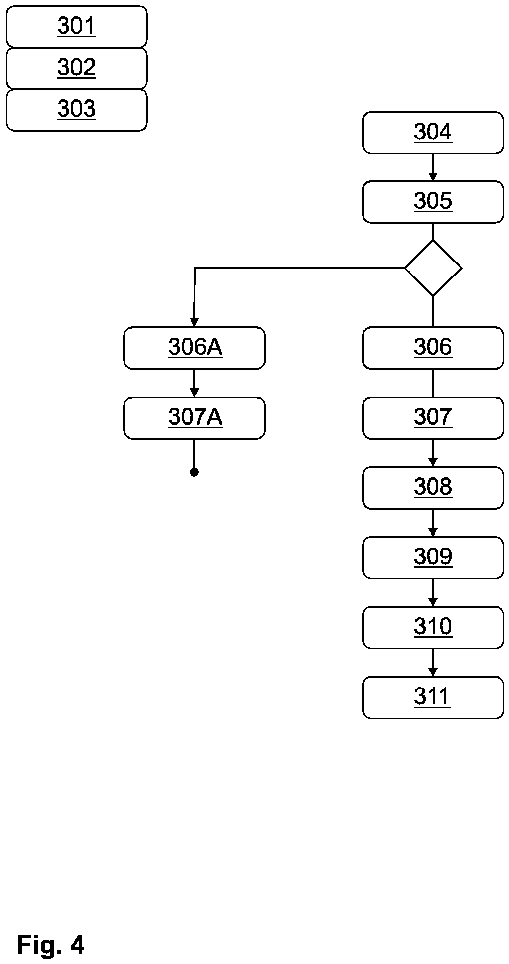

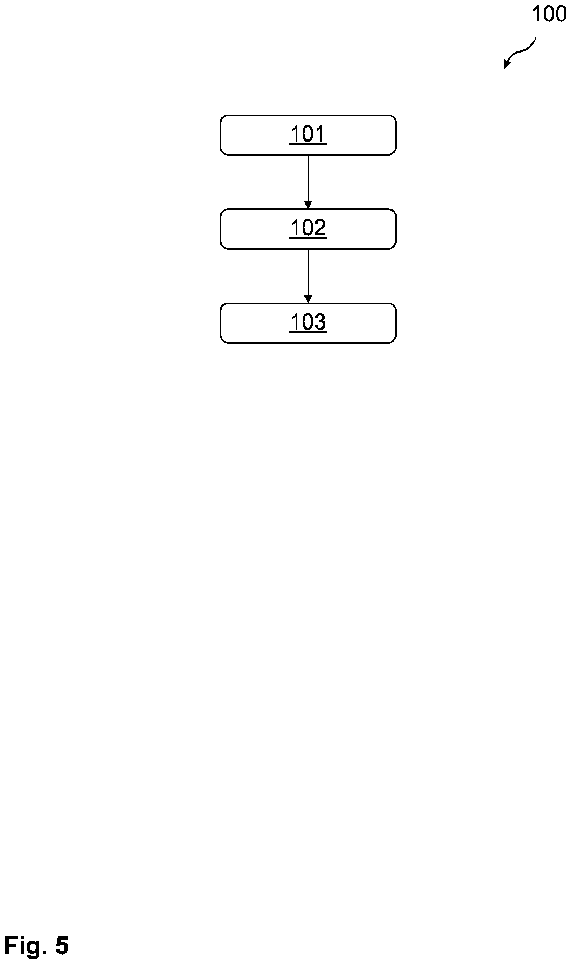

In Fig. 4 und 5 sind Verfahrensschritte des Verfahrens 100 visualisiert, bei welchem eine computer-gestützte Prüfung eines Installationselements, insbesondere eines Bauteils und/oder Kabels und/oder Steckverbinders, für eine Installationsumgebung durchgeführt wird. Erfindungsgemäß ist gemäß einem in Fig. 5 dargestellten ersten Verfahrensschritt 101 ein Prüfen einer Eignung des Installationselements für eine Installation in der Installationsumgebung vorgesehen.

Dabei wird diese auf Basis einer Kompatibilitätsbeurteilung mindestens einer Eigenschaft des Installationselements in Relation zu mindestens einer Eigenschaft der Installationsumgebung, insbesondere einer Temperatur und/oder Luftfeuchtigkeit und/oder elektrischen Spannung und/oder Beschleunigung überprüft. Anschließend erfolgt gemäß einem zweiten Verfahrensschritt 102 ein Generieren wenigstens einer Installationsinformation auf Basis eines Ergebnisses des Prüfens im ersten Verfahrensschritts zur Unterstützung eines Benutzers bei der Installation. Sodann erfolgt gemäß einem dritten Verfahrensschritt 103 ein Initiieren einer Ausgabe der generierten wenigstens einen Installationsinformation für den Benutzer erfolgen.

Durch die Dokumentation der Prüfung und der Installation, d.h. der Installationsdokumentation, kann z. B. wenigstens einer der folgenden Informationen dokumentiert werden: Arbeitsschritte des Benutzers mit Zusatzinformationen zu den Arbeitsschritten wie eine Bearbeitungsdauer, an welcher Maschine wird gearbeitet, welcher Benutzer, beispielsweise welcher Installateur oder Monteur, hat wann die Tätigkeiten durchgeführt, welches Bauteil ist verdrahtet und/ oder verkabelt worden, ist der Montageschritt abgeschlossen, welcher Port/welche Anschlussstelle wurde verwendet, existieren offene Kabel und was sind die Eigenschaften des offenen Kabels, z.B. Länge, Umgebungsparameter, z.B. Temperatur, Luftfeuchtigkeit, aktueller Projektstand, Schutzklasse, z.B. IP67. Auch kann der Benutzer, insbesondere Werker, bei Abweichungen hinsichtlich der validierten Installationshandlungen den Anlass, Grund oder die Beanstandung eingeben. Die Installationsdokumentation kann bspw. in einer Datenbank hinterlegt werden. Ein Benutzer kann ggf. mit physischen Handlungen (Tastendruck, Bildschirm, Doppelklick), die Dokumentation auslösen.

In Fig. 4 ist ein Verfahren 100 gemäß Ausführungsbeispielen der Erfindung mit weiteren Einzelheiten visualisiert. Über einen in Fig. 3 dargestellten Computer 31, wie ein Tablet oder Laptop, kann ein Benutzer zunächst eine Nutzeranmeldung 301 durchführen. Hierzu kann der Nutzer eine grafische Benutzeroberfläche 32 nutzen, welche durch den Computer 31 bereitgestellt wird. Ebenfalls über die Benutzeroberfläche 32 kann eine Projektauswahl 302 erfolgen, durch welche bspw. eine Installationsvorgabe 200 für ein gewünschtes Projekt geladen wird. Damit ist es möglich, einen Beginn 303 für die Prüfung eines Installationselements 10, insbesondere eines Bauteils 10 und/oder Kabels 10 und/oder Steckverbinders 10, für eine Installationsumgebung.

Bei der Installation des Installationselements 10 oder Bauteils 10, beispielsweise eines Kabels 10, in einer Installationsumgebung erfolgt gemäß dem Verfahrensschritt 304 zunächst eine Identifikation des Bauteils 10 durch eine Lesevorrichtung zur Vorbereitung der Prüfung und der Installation. So kann der Identifikator 11 beispielsweise eine Information bezüglich einer oder mehrerer technischen Eigenschaften des Kabels u.a. beispielsweise einer Länge des Kabels 10 umfassen. Der Identifikator 11 kann von der Lesevorrichtung durch ein Scannen gelesen oder erfasst werden, wobei der Identifikator 11 beispielsweise als maschinenlesbarer Code oder als aufgedruckter Code auf dem Kabel 11 angeordnet sein kann. Optional kann dieser Identifikationsschritt durch die Lesevorrichtung während des Verfahrens oder zu einem vom Benutzer als geeignet ausgewählten Zeitpunkt wiederholt durchgeführt werden, um den Identifikator nochmals zu erfassen.

Gemäß Verfahrensschritt 305 erfolgt daran anschließend die Prüfung beispielsweise auf Basis eines Abgleichs der Produkt- und/oder Materialeigenschaften des Kabels 10 mit den Umgebungsbedingungen hinsichtlich einer Kompatibilität durchgeführt. D.h. es wird anhand der Produkteigenschaften geprüft, ob das verwendete Kabel 10 (Ist-Bauteil) dem geplanten Kabel (Soll-Bauteil) entsprechen. Anhand der erfassten, gemessenen Umgebungsbedingungen wird abgeglichen, ob die Installationsumgebung (Ist-Umgebung) der geplanten Umgebung (Soll-Umgebung) entspricht, d.h. die Eigenschaften der Installationsumgebung den Eigenschaften der geplanten Umgebung entsprechen. In anderen Worten erfolgt eine Prüfung hinsichtlich einer Kompatibilität oder einer fehlenden Übereinstimmung zwischen Bauteil 10 und Installationsumgebung.

Im Falle einer Übereinstimmung des Bauteils und der Umgebungsbedingungen mit den Plänen wird gemäß dem Verfahrensschritt 306a eine Installationsinformation, beispielsweise als eine Bestätigung der Eignung des Bauteils 10 generiert und gemäß Verfahrensschritt 307a die Ausgabe der Information initiiert.

Im Falle einer Nicht-Übereinstimmung einer Eigenschaft erfolgt gemäß Verfahrensschritt 306 entweder die Generierung eines Hinweises und/oder einer Fehlermeldung und daran anschließend gemäß Schritt 307 die Ausgabe initiiert. Oder optional kann im Falle einer Nicht-Übereinstimmung gemäß Schritt 306 auch wahlweise eine Suche nach möglichen alternativen Bauteilen für ein Bauteil 10 initiiert werden, die für die tatsächliche Installationsumgebung besser geeignet sein könnten. Diese Option wird als Hinweis in Schritt 306 generiert und die Ausgabe an den Benutzer in Schritt 307 initiiert. Optional kann weiter im Falle einer Nicht-Übereinstimmung gemäß Verfahrensschritt 306 auch eine Installationsanweisung oder eine Handlungsempfehlung generiert und in Schritt 307 die Ausgabe initiiert werden.

Bei der Feststellung einer Abweichung von Soll und Ist im Rahmen der Prüfung kann optional gemäß Verfahrensschritt 308 auf Planungsdaten mit hinterlegten Produkteigenschaften und/oder auf Planungsdaten mit hinterlegten Umgebungseigenschaften zugegriffen werden. Daran anschließend kann dann in Verfahrensschritt 309 ein Abgleich der Produkteigenschaften und -spezifikationen des Bauteils 10 mit den in den Planungsunterlagen hinterlegten Spezifikationen des vorgesehenen Bauteils erfolgen.

Mit anderen Worten kann bei der Prüfung nach Verfahrensschritt 305 als ein Ergebnis festgestellt werden, dass wenn das Ist-Bauteil dem Soll-Bauteil und die Ist-Umgebung der Soll-Umgebung entspricht, dann keine Abweichung von den Planungsunterlagen zu der tatsächlichen Situation besteht und daher optional eine Bestätigung der Eignung an den Benutzer ausgegeben wird. Wenn aber beispielsweise, das Ist-Bauteil dem Soll-Bauteil entspricht, aber die Ist-Umgebung sich von der Soll-Umgebung unterscheidet, wird diese Information als Installationsinformation in Form eines Hinweises generiert in Schritt 306a und in Schritt 307a als Ausgabe initiiert, umfassend dass die tatsächliche Umgebung von der geplanten Umgebung abweicht.

Bei der Feststellung einer Abweichung derart, dass ein Referenz- oder Grenzwert einer Eigenschaft eines Bauteils oder der Umgebung über- oder unterschritten wird, wird optional durch eine Simulation gemäß Verfahrensschritt 310 eine Auswirkung der Über- oder Unterschreitung des mindestens einen Referenz- oder Grenzwerts durch die Abweichung in den Eigenschaften der Umgebung von der planmäßigen Situation durchgeführt. Bei der Simulation kann als ein Ergebnis auftreten, dass die Funktionsfähigkeit des Bauteils nicht oder nicht-signifikant beeinträchtigt wird. Daher ist das planmäßige Bauteil für die Verwendung in der nicht-planmäßigen Installationsumgebung geeignet. Oder die Simulation ergibt, dass die Funktionsfähigkeit des Bauteils signifikant beeinträchtigt wird. Dann zeigt das ausgegebene Ergebnis, dass das planmäßige Bauteil für die Verwendung in der nicht-planmäßigen Umgebung nicht geeignet ist. In beiden Fällen wird das jeweilige Ergebnis als eine Warnmeldung generiert und ausgegeben. So erhält der Benutzer die Information, dass das planmäßige Bauteil nicht für die Verwendung in der nicht-planmäßigen Umgebung geeignet und die Funktionalität signifikant beeinträchtigt ist.

Bei der Simulation werden optional beispielsweise in einer Analyse die Anforderungen der tatsächlich gemessenen Umgebungseigenschaften mit den Eigenschaften des planmäßigen Bauteils kombiniert, um ein Anforderungsprofil für ein geeignetes Bauteil zu erstellen. Dieses Anforderungsprofil wird dann beispielsweise als Mindestanforderung für geeignete Bauteile verwendet, sodass alle in der Datenbank hinterlegten Bauteile auf eine bestmögliche Übereinstimmung mit den mindestens erforderlichen Eigenschaften analysiert werden können Die Überprüfung erfolgt dabei über den Vergleich der Produktinformationen zum Beispiel durch eine Anbindung an ein Produktdatenmanagementsystem bzw. an ein Produktlebenszyklusmanagementsystem, welches auch ein automatisiertes oder manuelles Auslesen sowie Einpflegen von Daten ermöglichen kann.

Optional kann gemäß Verfahrensschritt 311 eine Suche nach geeigneten Alternativbauteilen erfolgen, die für die Verwendung in der nicht-planmäßigen Umgebung geeignet sind und die Funktionalität der Maschine gewährleisten. Daraufhin erfolgt beispielsweise ein automatischer Abgleich mit allen in einer Datenbank hinterlegten Bauteile auf die bestmögliche Übereinstimmung der Bauteilspezifikationen mit den Spezifikationen des planmäßigen Bauteils. Dabei ist vorgegeben, dass eine geeignete Alternative ein Bauteil ist, welches sich in der mindestens einen Eigenschaft, hinsichtlich welcher sich das planmäßige Bauteil nicht zur Verwendung in der nicht-planmäßigen Umgebung eignet, insofern unterscheidet, als dass die funktionsrelevanten Grenzwerte eingehalten werden.

Bei der Suche gemäß Schritt 311 kann sich zusätzlich ergeben, dass entweder keines der Bauteile 10, die beispielsweise an einem Installationsstandort verfügbar sein können, die Mindestanforderungen der nicht-planmäßigen Umgebungseigenschaften gewährleisten oder aber mindestens ein geeignetes Bauteil 10 ist in einem anderen Lager für die Installation verfügbar. In letzterem Fall wird dann beispielsweise eine Liste mit geeigneten Alternativen generiert und die Listenauswahl als Ausgabe an den Benutzer initiiert. Optional kann auch eine Materialbestellung nach Wahl des Benutzers erfolgen.

In einem weiteren Fall kann das Ergebnis der Suche sein, dass keines der verfügbaren Bauteile und keines der in einem Lager vorrätigen Bauteile die Mindestanforderungen der nicht-planmäßigen Umgebungseigenschaften gemäß der Simulation erfüllt. Dann wird zum Beispiel Hinweis generiert und an den Benutzer ausgegeben, dass es kein besser geeignetes Bauteil gibt als das planmäßig vorgesehene.

Ferner kann die Suche auch ergeben, dass eines der verfügbaren Bauteile 10 die Mindestanforderungen der nicht-planmäßigen Umgebungseigenschaften erfüllt und somit als Alternative für das planmäßige Bauteil geeignet ist. Ein solches Ergebnis kann dann als eine Installationsinformation generiert werden, der das alternative Bauteil als eine Installationsempfehlung umfasst. Die Empfehlung kann anschließend an den Benutzer ausgegeben werden.

Obwohl einige Aspekte im Zusammenhang mit einer Vorrichtung beschrieben wurden, ist es klar, dass diese Aspekte auch eine Beschreibung des entsprechenden Verfahrens darstellen, wobei ein Element oder eine Vorrichtung einem Verfahrensschritt oder einem Merkmal eines Verfahrensschritts entspricht. Analog dazu stellen Aspekte, die im Zusammenhang mit einem Verfahrensschritt beschrieben werden, auch eine Beschreibung eines entsprechenden Blocks oder Elements oder Merkmals eines entsprechenden Geräts dar.

Ausführungsformen der Erfindung können auf einem Computersystem implementiert werden. Bei dem Computersystem kann es sich um ein lokales Computergerät (z. B. Personalcomputer, Laptop, Tablet-Computer oder Mobiltelefon) mit einem oder mehreren Prozessoren und einem oder mehreren Speichergeräten handeln oder um ein verteiltes Computersystem (z. B. ein Cloud-Computersystem mit einem oder mehreren Prozessoren und einem oder mehreren Speichergeräten, die an verschiedenen Orten verteilt sind, z. B. bei einem lokalen Client und/oder einer oder mehreren entfernten Serverfarmen und/oder Datenzentren). Das Computersystem kann jede beliebige Schaltung oder Kombination von Schaltungen umfassen. In einer Ausführungsform kann das Computersystem einen oder mehrere Prozessoren beliebiger Art umfassen. Der hier verwendete Begriff "Prozessor" kann jede Art von Rechenschaltung bezeichnen, z. B. einen Mikroprozessor, einen Mikrocontroller, einen CISC-Mikroprozessor (Complex Instruction Set Computing), einen RISC-Mikroprozessor (Reduced Instruction Set Computing), einen VLlW-Mikroprozessor (Very Long Instruction Word), einen Grafikprozessor, einen digitalen Signalprozessor (DSP), einen Mehrkernprozessor, ein FPGA (Field Programmable Gate Array) oder jede andere Art von Prozessor oder Verarbeitungsschaltung. Andere Arten von Schaltkreisen, die im Computersystem enthalten sein können, können ein kundenspezifischer Schaltkreis, ein anwendungsspezifischer integrierter Schaltkreis (ASIC) oder ähnliches sein, wie z. B. ein oder mehrere Schaltkreise (z. B. ein Kommunikationsschaltkreis) zur Verwendung in drahtlosen Geräten wie Mobiltelefonen, Tablet-Computern, Laptop-Computern, Zwei-Wege-Funkgeräten und ähnlichen elektronischen Systemen. Das Computersystem kann eine oder mehrere Speichervorrichtungen enthalten, die ein oder mehrere für die jeweilige Anwendung geeignete Speicherelemente umfassen können, wie z. B. einen Hauptspeicher in Form eines Direktzugriffsspeichers (RAM), eine oder mehrere Festplatten und/oder ein oder mehrere Laufwerke, die Wechseldatenträger wie Compact Disks (CD), Flash-Speicherkarten, digitale Videodisks (DVD) und dergleichen verarbeiten. Das Computersystem kann auch ein Anzeigegerät, einen oder mehrere Lautsprecher und eine Tastatur und/oder ein Steuergerät enthalten, das eine Maus, einen Trackball, einen Touchscreen, ein Spracherkennungsgerät oder ein anderes Gerät umfassen kann, das es einem Systembenutzer ermöglicht, Informationen in das Computersystem einzugeben und Informationen von ihm zu empfangen.

Einige oder alle Verfahrensschritte können von einem Hardware-Gerät (oder unter Verwendung eines solchen) ausgeführt werden, wie z. B. einem Prozessor, einem Mikroprozessor, einem programmierbaren Computer oder einer elektronischen Schaltung. In einigen Ausführungsformen können einige oder mehrere der wichtigsten Verfahrensschritte von einem solchen Gerät ausgeführt werden.

Abhängig von bestimmten Implementierungsanforderungen können Ausführungsformen der Erfindung in Hardware oder in Software implementiert werden. Die Implementierung kann unter Verwendung eines nicht-übertragbaren Speichermediums wie eines digitalen Speichermediums, beispielsweise einer Diskette, einer DVD, einer Blu-Ray, einer CD, eines ROM, eines PROM, eines EPROM, eines EEPROM oder eines FLASH-Speichers erfolgen, auf dem elektronisch lesbare Steuersignale gespeichert sind, die mit einem programmierbaren Computersystem zusammenwirken (oder zusammenwirken können), so dass das jeweilige Verfahren durchgeführt wird. Daher kann das digitale Speichermedium computerlesbar sein.

Einige Ausführungsformen der Erfindung umfassen einen Datenträger mit elektronisch lesbaren Steuersignalen, die in der Lage sind, mit einem programmierbaren Computersystem zusammenzuarbeiten, so dass eines der hier beschriebenen Verfahren durchgeführt wird.

Im Allgemeinen können Ausführungsformen der vorliegenden Erfindung als Computerprogrammprodukt mit einem Programmcode implementiert werden, wobei der Programmcode zur Durchführung eines der Verfahren dient, wenn das Computerprogrammprodukt auf einem Computer läuft. Der Programmcode kann zum Beispiel auf einem maschinenlesbaren Träger gespeichert sein.

Andere Ausführungsformen umfassen das Computerprogramm zur Durchführung eines der hier beschriebenen Verfahren, das auf einem maschinenlesbaren Träger gespeichert ist.

Mit anderen Worten, eine Ausführungsform der vorliegenden Erfindung ist daher ein Computerprogramm mit einem Programmcode zur Durchführung eines der hierin beschriebenen Verfahren, wenn das Computerprogramm auf einem Computer läuft.

Eine weitere Ausführungsform der vorliegenden Erfindung ist daher ein Speichermedium (oder ein Datenträger oder ein computerlesbares Medium), auf dem das Computerprogramm zur Durchführung eines der hierin beschriebenen Verfahren gespeichert ist, wenn es von einem Prozessor ausgeführt wird. Der Datenträger, das digitale Speichermedium oder das aufgezeichnete Medium sind typischerweise greifbar und/oder nicht-übertragbar. Eine weitere Ausführungsform der vorliegenden Erfindung ist ein Gerät, wie hierin beschrieben, mit einem Prozessor und dem Speichermedium.

Eine weitere Ausführungsform der Erfindung ist daher ein Datenstrom oder eine Folge von Signalen, die das Computerprogramm zur Durchführung eines der hierin beschriebenen Verfahren darstellen. Der Datenstrom bzw. die Signalfolge kann beispielsweise so ausgestaltet sein, dass er bzw. sie über eine Datenkommunikationsverbindung, z.B. über das Internet, übertragen werden kann.

Eine weitere Ausführungsform umfasst ein Verarbeitungsmittel, z. B. einen Computer oder ein programmierbares Logikgerät, das so konfiguriert oder angepasst ist, dass es eines der hierin beschriebenen Verfahren durchführen kann.

Eine weitere Ausführungsform umfasst einen Computer, auf dem das Computerprogramm zur Durchführung eines der hierin beschriebenen Verfahren installiert ist.

Eine weitere Ausführungsform der Erfindung umfasst eine Vorrichtung oder ein System, die bzw. das so konfiguriert ist, dass sie bzw. es ein Computerprogramm zur Durchführung eines der hierin beschriebenen Verfahren an einen Empfänger überträgt (z. B. auf elektronischem oder optischem Weg). Bei dem Empfänger kann es sich beispielsweise um einen Computer, ein mobiles Gerät, ein Speichergerät oder dergleichen handeln. Die Vorrichtung oder das System kann zum Beispiel einen Dateiserver zur Übertragung des Computerprogramms an den Empfänger umfassen.

In einigen Ausführungsformen kann eine programmierbare Logikvorrichtung (z. B. ein feldprogrammierbares Gate-Array) verwendet werden, um einige oder alle Funktionen der hier beschriebenen Verfahren auszuführen. In einigen Ausführungsformen kann ein feldprogrammierbares Gate-Array mit einem Mikroprozessor zusammenarbeiten, um eines der hier beschriebenen Verfahren durchzuführen. Im Allgemeinen werden die Verfahren vorzugsweise von einem beliebigen Hardware-Gerät durchgeführt.

### Liste der Bezugszeichen

- 1: Maschine, Anlage
- 2: System
- 3: Mastermodul
- 4: Modul, Switch, Komponente, Verbindungsmodul
- 5: Geräte, Sensor, Aktor
- 6: Hub
- 8: Steuerungsvorrichtung, SPS
- 9: Schaltschrank

- 10: Installationselement
- 11: Identifikator
- 12: Identifikationsmittel, maschinenlesbarer Code
- 13: Energieversorgung

- 20: Computerprogramm
- 21: Bussystem
- 22: Detektionsvorrichtung

- 30: Vorrichtung
- 31: Computer
- 32: Benutzeroberfläche
- 33: Datenspeicher

- 41: Anzeigeelement
- 42: Anschlussstelle, Steckplatz

- 100: Verfahren
- 101: erster Verfahrensschritt
- 102: zweiter Verfahrensschritt
- 103: dritter Verfahrensschritt

- 200: Installationsvorgabe
- 301: Nutzeranmeldung
- 302: Projektauswahl
- 303: Beginn Anleitung
- 304: Identifikation
- 305: Prüfen
- 306: Generieren
- 307: Initiieren einer Ausgabe
- 308: Zugreifen auf hinterlegte Daten
- 309: Abgleichen Eigenschaften
- 310: Simulation
- 311: Suche

## Patentansprüche

1. Ein Verfahren (100) für eine computer-gestützte Prüfung eines Installationselements (10) für eine Installationsumgebung, wobei das Verfahren (100) die nachfolgenden Schritte umfasst:
Prüfen (101) einer Eignung des Installationselements (10) für eine Installation in der Installationsumgebung auf Basis einer Kompatibilitätsbeurteilung mindestens einer Eigenschaft des Installationselements (10) in Relation zu mindestens einer Eigenschaft der Installationsumgebung;
Generieren (102) wenigstens einer Installationsinformation auf Basis eines Ergebnisses des Prüfens (101) zur Unterstützung eines Benutzers bei der Installation; und
Initiieren (103) einer Ausgabe der generierten wenigstens einen Installationsinformation für den Benutzer, **dadurch gekennzeichnet, dass** das Verfahren (100) bei dem Prüfen (101) der Eignung den nachfolgenden weiteren Schritt umfasst:
Überprüfen der Einhaltung mindestens eines Referenz- und/oder Grenzwertes für die mindestens eine Eigenschaft des Installationselements (10), wobei die nachfolgenden Schritte durchgeführt werden, wenn eine Abweichung der mindestens einen Eigenschaft des Installationselements (10) von dem mindestens einen Referenz- und/oder Grenzwert festgestellt wird:
Simulieren einer negativen Auswirkung der Abweichung, um ein weiteres Installationselement (10) zu spezifizieren, durch dessen Einsatz die negative Auswirkung neutralisiert wird;
Generieren einer Ausgabe der wenigstens einen Installationsinformation in Abhängigkeit eines Ergebnisses des Simulierens, wobei bei der Ausgabe eine Liste von geeigneten Installationselementen (10) für die Installationsumgebung ausgegeben wird.

2. Das Verfahren (100) nach Anspruch 1, wobei die wenigstens eine Installationsinformation eine Installationsanweisung zur Unterstützung des Benutzers bei der Installation umfasst;
wobei vorzugsweise das Initiieren (103) der Ausgabe zumindest einen der nachfolgenden Schritte umfasst:
Initiieren einer Ausgabe der Installationsanweisung als eine Angabe einer Anschlussstelle (42) einer elektrischen Komponente (4) für einen Anschluss des Installationselements (10) und/oder einer Angabe zur Eignung des Installationselements (10), vorzugsweise als Angabe für den Benutzer, dass das Installationselement (10) für die Verwendung in der Installationsumgebung geeignet ist;
Initiieren einer visuellen Ausgabe der Installationsanweisung, vorzugsweise durch eine grafische Benutzeroberfläche (32) und/oder mittels Erweiterter Realität und/oder durch einen Signalgeber der elektrischen Komponente (4);
Initiieren einer akustischen Ausgabe, insbesondere einer Sprachausgabe, der Installationsanweisung.

3. Das Verfahren (100) nach einem der vorhergehenden Ansprüche, wobei bei dem Initiieren (103) der Ausgabe wenigstens einer der nachfolgenden Schritte durchgeführt wird, wenn anhand des Ergebnisses des Prüfens (101) die Eignung des Installationselements (10) für die Installation in der Installationsumgebung als unzureichend festgestellt wird:
Initiieren einer Ausgabe eines Warnhinweises und/oder einer Fehlermeldung, vorzugsweise des Warnhinweises und/oder der Fehlermeldung, dass das Installationselement (10) nicht für die Verwendung in der Installationsumgebung geeignet ist und eine Funktionalität des Installationselements (10) signifikant beeinträchtigt ist;
Initiieren einer Ausgabe einer Installationsanweisung und/oder einer Handlungsempfehlung, vorzugsweise mit einer Angabe eines anderen Installationselements (10) mit einer höheren Eignung als das geprüfte Installationselement (10) für die Installation in der Installationsumgebung.

4. Das Verfahren (100) nach einem der vorhergehenden Ansprüche, wobei das Verfahren (100) den nachfolgenden weiteren Schritt umfasst:
Automatisches Dokumentieren der Eignung des Installationselements (10) in Abhängigkeit des Ergebnisses des Prüfens (101).

5. Das Verfahren (100) nach einem der vorhergehenden Ansprüche, wobei das Verfahren (100) den nachfolgenden weiteren Schritt umfasst:
Bereitstellen von Installationsdaten des Installationselements (10), insbesondere eines Kabels und/oder Steckverbinders, wobei die Installationsdaten Planungsdaten für die mindestens eine Eigenschaft des Installationselements (10) umfassen.

6. Das Verfahren (100) nach einem der vorhergehenden Ansprüche, wobei das Verfahren (100) den nachfolgenden weiteren Schritt umfasst:
Bereitstellen von Installationsdaten der Installationsumgebung, wobei die Installationsdaten Planungsdaten für die mindestens eine Eigenschaft der Installationsumgebung umfassen.

7. Das Verfahren (100) nach einem der vorhergehenden Ansprüche, wobei die mindestens eine Eigenschaft des Installationselements (10) zumindest eine der folgenden umfasst:
einen zulässigen Temperaturbereich, für welchen das Installationselement (10) geeignet ist;
einen Bereich einer Luftfeuchtigkeit, für welchen das Installationselement (10) geeignet ist;
einen elektrische Nennspannung, für welche das Installationselement (10) geeignet ist;
eine zulässige Beschleunigung, für welche das Installationselement (10) geeignet ist;
einen minimalen Biegeradius, für welchen das Installationselement (10) geeignet ist;
eine minimale und/oder maximale mechanische Belastung, für welche das Installationselement geeignet ist;
eine minimale und/oder maximale Anzahl an Adern innerhalb des Steckverbinders und/oder Kabels;
eine Kodierung des Steckverbinders als Signalleitung A-, B-, C-, D-, oder X-Kodiert und/oder als Powerleitung A-, K-, L und/oder als Datenleitung A-, B-, D-, X-, und Y-Kodiert und/oder mit LED und/oder Kodierung als geschirmter oder ungeschirmter Steckverbinder und/oder einer Hybridleitung, insbesondere als Kombination aus den vorgenannten Leitungen;
einen spezifischen Kabelabgang, vorzugsweise eines Steckers für einen Bereich von 0° - bis 90°, bevorzugt 45° bis 60°, für welchen das Installationselement geeignet ist;
einen spezifischen Anschluss auf den jeweiligen Seiten, für welche ein Installationselement geeignet ist, insbesondere als M8-, M12-, M23-, RJ45-, 7/8 (siebenachtel)-, MQ15-, MSUD- (Ventilstecker), Deutschstecker- oder RJ45PP-Anschluss;
einen spezifischen Steckverbindertyp für welche das Installationselement geeignet ist, insbesondere ein Steckverbindertyp vom Typ Buchse-Buchse, Buchse-Stecker, Stecker-Buchse oder Stecker-Stecker, H-, T- und Y- Stücke und Verteiler;
eine spezifische Anwendung für welche das Installationselement geeignet ist, insbesondere als AS-Interface, als Ethernet-, als Motoren-, als Feldbus- Anwendung oder Sensor-/Aktor-Leitung;
eine entsprechende Bauform des Installationselements in Abhängigkeit der Umgebung, für welche das Installationselement geeignet ist;
eine Sicherheits- und/ oder Redundanzanforderung, für welche das Installationselement geeignet ist.

8. Das Verfahren (100) nach einem der vorhergehenden Ansprüche, wobei die mindestens eine Eigenschaft der Installationsumgebung zumindest eine der folgenden umfasst:
einen Temperaturbereich, welcher in der Installationsumgebung als Lufttemperatur vorgesehen ist;
eine Luftfeuchtigkeit, welche in der Installationsumgebung vorgesehen ist;
eine Nässe, welche in der Installationsumgebung vorgesehen ist;
eine elektrische Spannung, welche als Betriebsspannung für das Installationselement (10) vorgesehen ist;
eine Chemikalienresistenz, welche in der Installationsumgebung vorgesehen ist;
einen Luftdruck, welcher in der Installationsumgebung vorgesehen ist;
eine UV-Belastung, welche in der Installationsumgebung vorgesehen ist;
eine bakterielle Belastung, welche in der Installationsumgebung vorgesehen ist;
eine biologische Belastung, welche in der Installationsumgebung vorgesehen ist;
eine zulässige Beschleunigung, für welchen das Installationselement (10) geeignet ist;
eine Vibration, welche in der Installationsumgebung vorgesehen ist;
eine Geräuschbelastung, welche in der Installationsumgebung vorgesehen ist;
ein Körperschall, welche in der Installationsumgebung vorgesehen ist;
eine entsprechende Bauform des Installationselements in Abhängigkeit der Einsatzbranche, für welche das Installationselement geeignet ist.

9. Das Verfahren (100) nach einem der vorhergehenden Ansprüche, wobei das Prüfen (101) der Eignung des Installationselements (10) für die Installation in der Installationsumgebung die nachfolgenden Schritte umfasst:
Ermitteln der mindestens einen Eigenschaft des Installationselements (10), bevorzugt aus einer Datenbank und/oder aus einem Datenspeicher, wobei die mindestens eine Eigenschaft jeweils eine Anforderung an einen Parameter der Installationsumgebung definiert und/oder einen technischen Parameter des Installationselements (10) angibt;
Ermitteln der mindestens einen Eigenschaft der Installationsumgebung, bevorzugt durch eine Messung und/oder aus einer Datenbank und/oder aus einem Datenspeicher, wobei die mindestens eine Eigenschaft jeweils eine Anforderung an den technischen Parameter des Installationselements (10) definiert und/oder den Parameter der Installationsumgebung angibt;
Durchführen der Kompatibilitätsbeurteilung durch eine Überprüfung der mindestens einen Anforderung, um bei einer Erfüllung die Eignung des Installationselements (10) für die Installation in der Installationsumgebung als ausreichend und andernfalls als unzureichend festzustellen.

10. Das Verfahren (100) nach einem der vorhergehenden Ansprüche, wobei das Verfahren (100) den nachfolgenden weiteren Schritt umfasst:
Empfangen eines Identifikators (11) des Installationselements (10), vorzugsweise von einem Lesegerät, bevorzugt durch einen Scanner, um die Eignung des Installationselements (10) für die Installationsumgebung zu überprüfen;
Auslesen von mindestens einer Eigenschaft des Installationselements (10) aus einer Datenbank auf Basis des empfangenen Identifikators (11).

11. Das Verfahren (100) nach einem der vorhergehenden Ansprüche, wobei das Installationselement (10) in der Form eines Bauteils und/oder Kabels und/oder Steckverbinders ausgebildet ist, und/oder
dass das Verfahren für die computer-gestützte Prüfung des Installationselements für die Installationsumgebung bei einer Installation von räumlich dezentral angeordneten, elektrischen Komponenten (4) einer Maschine (1), insbesondere einer Anlage (1), ausgeführt ist, und/oder
dass der Schritt des Prüfens (101) der Eignung des Installationselements (10) für die Installation in der Installationsumgebung auf Basis einer Kompatibilitätsbeurteilung mindestens einer Eigenschaft des Installationselements (10) in Relation zu mindestens einer Eigenschaft der Installationsumgebung, insbesondere einer Temperatur und/oder Luftfeuchtigkeit und/oder elektrischen Spannung und/oder Beschleunigung, durchgeführt wird.

12. Das Verfahren nach Anspruch 11, wobei die nachfolgenden Schritte durchgeführt werden, wenn eine Abweichung der mindestens einen Eigenschaft des Installationselements (10) von dem mindestens einen Referenz- und/oder Grenzwert festgestellt wird:
Simulieren einer Auswirkung der Abweichung, um in Abhängigkeit von der Auswirkung die Eignung des Installationselements (10) für die Installation in der Installationsumgebung festzustellen;
Spezifizieren eines weiteren Installationselements (10), das für die Verwendung in der Installationsumgebung eine höhere Eignung aufweist und/oder eine Funktionalität der Maschine (1) gewährleistet, falls die Eignung als unzureichend festgestellt wird; und
Generieren einer Ausgabe der Installationsinformation in Abhängigkeit eines Ergebnisses des Simulierens, wobei vorzugsweise eine Liste von geeigneten Installationselementen (10) für die Installationsumgebung ausgegeben wird.

13. Eine Vorrichtung (30) zur Datenverarbeitung mit Mitteln zur Durchführung des Verfahrens (100) nach einem der vorhergehenden Ansprüche.

14. Ein Computerprogramm (20) umfassend Anweisungen, die, wenn das Programm von einem Computer (31) ausgeführt wird, den Computer (31) veranlassen, das Verfahren (100) nach einem der Ansprüche 1 bis 12 auszuführen.

## Claims

1. A method (100) for a computer-aided verifying of an installation element (10) for an installation environment, the method (100) comprising the following steps:
Verifying (101) a suitability of the installation element (10) for an installation in the installation environment based on a compatibility assessment of at least one property of the installation element (10) in relation to at least one property of the installation environment;
Generating (102) at least one installation information based on a result of the verifying (101) to assist a user during installation; and
Initiating (103) an output of the generated at least one installation information for the user,
**characterized in that** the method (100) comprises the following further step when verifying (101) the suitability:
Checking a compliance with at least one reference and/or limit value for the at least one property of the installation element (10),
wherein the following steps are carried out if a deviation of the at least one property of the installation element (10) from the at least one reference and/or limit value is detected:
Simulating a negative effect of the deviation in order to specify a further installation element (10), the use of which neutralizes the negative effect;
Generating an output of the at least one installation information as a function of a result of the simulation, wherein a list of suitable installation elements (10) for the installation environment is output.

2. The method (100) according to claim 1, wherein the at least one installation information comprises an installation instruction to assist the user during the installation;
wherein preferably initiating (103) the output comprises at least one of the following steps:
Initiating an output of the installation instruction as an indication of a connection point (42) of an electrical component (4) for a connection of the installation element (10) and/or an indication of a suitability of the installation element (10), preferably as an indication to the user that the installation element (10) is suitable for use in the installation environment;
Initiating a visual output of the installation instruction, preferably by a graphical user interface (32) and/or by means of augmented reality and/or by a signal transmitter of the electrical component (4);
Initiating an acoustic output, in particular a voice output, of the installation instruction.

3. The method (100) according to any one of the preceding claims, wherein upon initiating (103) the output, at least one of the subsequent steps is performed if the suitability of the installation element (10) for installation in the installation environment is determined to be insufficient based on the result of the verifying (101):
Initiating an output of a warning and/or error message, preferably the warning and/or error message that the installation element (10) is not suitable for use in the installation environment and a functionality of the installation element (10) is significantly impaired;
Initiating an output of an installation instruction and/or a recommended action, preferably with an indication of another installation element (10) with a higher suitability than the verified installation element (10) for the installation in the installation environment.

4. The method (100) according to any one of the preceding claims, wherein the method (100) comprises the following further step:
Automatic documentation of the suitability of the installation element (10) depending on the result of the verifying (101).

5. The method (100) according to any one of the preceding claims, wherein the method (100) comprises the following further step:
Providing installation data of the installation element (10), in particular of a cable and/or plug connector, the installation data comprising planning data for the at least one property of the installation element (10).

6. The method (100) according to any one of the preceding claims, wherein the method (100) comprises the following further step:
Providing installation data of the installation environment, wherein the installation data comprises planning data for the at least one property of the installation environment.

7. The method (100) according to any one of the preceding claims, wherein the at least one property of the installation element (10) comprises at least one of the following:
a permissible temperature range for which the installation element (10) is suitable;
a range of humidity for which the installation element (10) is suitable;
a nominal electrical voltage for which the installation element (10) is suitable;
a permissible acceleration for which the installation element (10) is suitable;
a minimum bending radius for which the installation element (10) is suitable;
a minimum and/or maximum mechanical load for which the installation element is suitable;
a minimum and/or maximum number of wires within the plug connector and/or cable;
coding of the connector as a signal line A-, B-, C-, D-, or X-coded and/or as a power line A-, K-, L and/or as a data line A-, B-, D-, X-, and Y-coded and/or with LED and/or coding as a shielded or unshielded connector and/or a hybrid line, in particular as a combination of the aforementioned lines;
a specific cable outlet, preferably a plug for a range of 0° - to 90°, preferably 45° to 60°, for which the installation element is suitable;
a specific connection on the respective sides for which an installation element is suitable, in particular as an M8, M12, M23, RJ45, 7/8 (seven-eighths), MQ15, MSUD (valve connector), Deutschstecker or RJ45PP connection;
a specific plug connector type for which the installation element is suitable, in particular a connector type of the type socket-socket, socket-plug, plug-socket or plug-plug, H, T and Y pieces and distributors;
a specific application for which the installation element is suitable, in particular as an AS-Interface, Ethernet, motor, fieldbus application or sensor/actuator cable;
an appropriate design of the installation element depending on the environment for which the installation element is suitable;
a safety and/or redundancy requirement for which the installation element is suitable.

8. The method (100) according to any one of the preceding claims, wherein the at least one property of the installation environment comprises at least one of the following:
a temperature range, which is intended as the air temperature in the installation environment;
a humidity level that is intended for the installation environment;
a wetness which is provided in the installation environment;
an electrical voltage which is provided as the operating voltage for the installation element (10);
a chemical resistance which is provided for in the installation environment;
an air pressure which is provided for in the installation environment;
a UV exposure that is intended in the installation environment;
a bacterial load, which is provided for in the installation environment;
a biological load that is intended in the installation environment;
a permissible acceleration for which the installation element (10) is suitable;
a vibration that is provided in the installation environment;
a noise load that is intended in the installation environment;
a structure-borne sound, which is provided for in the installation environment;
a corresponding design of the installation element depending on the application sector for which the installation element is suitable.

9. The method (100) according to any one of the preceding claims, wherein verifying (101) the suitability of the installation element (10) for the installation in the installation environment comprises the following steps:
Determining the at least one property of the installation element (10), preferably from a database and/or from a data memory, where the at least one property in each case defines a requirement for a parameter of the installation environment and/or specifies a technical parameter of the installation element (10);
Determining the at least one property of the installation environment, preferably by a measurement and/or from a database and/or from a data memory, wherein the at least one property in each case defines a requirement for the technical parameter of the installation element (10) and/or specifies the parameter of the installation environment;
Performing the compatibility assessment by checking the at least one requirement to determine the suitability of the installation element (10) for the installation in the installation environment as sufficient if fulfilled and insufficient otherwise.

10. The method (100) according to any one of the preceding claims, wherein the method (100) comprises the following further step:
Receiving an identifier (11) of the installation element (10), preferably from a reader device, preferably by a scanner, in order to check the suitability of the installation element (10) for the installation environment;
Reading out at least one property of the installation element (10) from a database based on the received identifier (11).

11. The method (100) according to one of the preceding claims, wherein the installation element (10) is designed in the form of a component and/or cable and/or plug connector, and/or in that the method for the computer-aided testing of the installation element for the installation environment for an installation of spatially decentralized electrical components (4) of a machine (1), in particular a plant (1), and/or in that the step of verifying (101) the suitability of the installation element (10) for the installation in the installation environment is carried out based on a compatibility assessment of at least one property of the installation element (10) in relation to at least one property of the installation environment, in particular a temperature and/or humidity and/or electrical voltage and/or acceleration.

12. The method according to claim 11, wherein the following steps are performed if a deviation of the at least one property of the installation element (10) from the at least one reference and/or limit value is detected:
Simulating an effect of the deviation in order to determine the suitability of the installation element (10) for installation in the installation environment depending on the effect;
Specifying a further installation element (10) which comprises a higher suitability for use in the installation environment and/or ensures functionality of the machine (1) if the suitability is determined to be insufficient; and
Generating an output of the installation information depending on a result of the simulation, preferably outputting a list of suitable installation elements (10) for the installation environment.

13. A data processing apparatus (30) comprising means for performing the method (100) according to any one of the preceding claims.

14. A computer program (20) comprising instructions, which, when the program is executed by a computer (31), cause the computer (31) to execute the method (100) according to any one of claims 1 to 12.

## Revendications

1. Procédé (100) de test assisté par ordinateur d'un élément d'installation (10) pour un environnement d'installation, le procédé (100) comprenant les étapes suivantes :
Test (101) d'une adéquation de l'élément d'installation (10) pour une installation dans l'environnement d'installation sur la base d'une évaluation de compatibilité d'au moins une propriété de l'élément d'installation (10) par rapport à au moins une propriété de l'environnement d'installation ;
Génération (102) d'au moins une information d'installation sur la base d'un résultat du test (101) pour aider un utilisateur lors de l'installation ; et
Initiation (103) d'une sortie de l'au moins une information d'installation générée pour l'utilisateur, **caractérisé en ce que** le procédé (100) comprend l'étape supplémentaire suivante lors du test (101) de l'adéquation :
Vérification du respect d'au moins une valeur de référence et/ou limite pour l'au moins une propriété de l'élément d'installation (10),
les étapes suivantes étant exécutées lorsqu'un écart de l'au moins une propriété de l'élément d'installation (10) par rapport à l'au moins une valeur de référence et/ou limite est détecté :
Simulation d'un effet négatif de l'écart pour spécifier un autre élément d'installation (10) dont l'utilisation neutralise l'effet négatif ;
Génération d'une sortie de l'au moins une information d'installation en fonction d'un résultat de la simulation, une liste d'éléments d'installation (10) adaptés
pour l'environnement d'installation étant émise lors de la sortie.

2. Procédé (100) selon la revendication 1, dans lequel l'au moins une information d'installation comprend une instruction d'installation pour aider l'utilisateur lors de l'installation ; de préférence, l'initiation (103) de la sortie comprenant au moins l'une des étapes suivantes :
Initiation d'une sortie de l'instruction d'installation comme une indication d'un emplacement de connexion (42) d'un composant électrique (4) pour une connexion de l'élément d'installation (10) et/ou une indication de l'adéquation de l'élément d'installation (10), de préférence comme une indication pour l'utilisateur que l'élément d'installation (10) est adapté pour une utilisation dans l'environnement d'installation ;
Initiation d'une sortie visuelle de l'instruction d'installation, de préférence par une interface utilisateur graphique (32) et/ou au moyen de la réalité augmentée et/ou par un générateur de signaux du composant électrique (4) ;
Initiation d'une sortie acoustique, en particulier une sortie vocale, de l'instruction d'installation.

3. Procédé (100) selon l'une des revendications précédentes, dans lequel, lors de l'initiation (103) de la sortie, au moins l'une des étapes suivantes est effectuée si, sur la base du résultat du test (101), l'adéquation de l'élément d'installation (10) pour l'installation dans l'environnement d'installation est déterminée comme étant insuffisante :
Initiation d'une sortie d'un avertissement et/ou d'un message d'erreur, de préférence l'avertissement et/ou le message d'erreur que l'élément d'installation (10) n'est pas adapté à l'utilisation dans l'environnement d'installation et qu'une fonctionnalité de l'élément d'installation (10) est significativement affectée ;
Initiation d'une sortie d'une instruction d'installation et/ou d'une recommandation d'action, de préférence avec une indication d'un autre élément d'installation (10) ayant une adéquation supérieure à l'élément d'installation (10) testé pour l'installation dans l'environnement d'installation.

4. Procédé (100) selon l'une des revendications précédentes, dans lequel le procédé (100) comprend l'étape supplémentaire suivante :
Documentation automatique de l'adéquation de l'élément d'installation (10) en fonction du résultat du test (101).

5. Procédé (100) selon l'une des revendications précédentes, le
procédé (100) comprenant l'étape supplémentaire suivante :
Mise à disposition de données d'installation de l'élément d'installation (10), en particulier d'un câble et/ou d'un connecteur, les données d'installation comprenant des données de planification pour l'au moins une propriété de l'élément d'installation (10).

6. Procédé (100) selon l'une des revendications précédentes, dans lequel le procédé (100) comprend l'étape supplémentaire suivante :
Mise à disposition des données d'installation de l'environnement d'installation, les données d'installation comprenant des données de planification pour l'au moins une propriété de l'environnement d'installation.

7. Procédé (100) selon l'une des revendications précédentes, dans lequel l'au moins une propriété de l'élément d'installation (10) comprend au moins l'une des propriétés suivantes :
une plage de température admissible pour laquelle l'élément d'installation (10) est adapté ;
une plage d'humidité de l'air pour laquelle l'élément d'installation (10) est adapté ;
une tension électrique nominale pour laquelle l'élément d'installation (10) est adapté ;
une accélération admissible pour laquelle l'élément d'installation (10) est adapté ;
un rayon de courbure minimal pour lequel l'élément d'installation (10) est adapté ;
une charge mécanique minimale et/ou maximale pour laquelle l'élément d'installation est adapté ;
un nombre minimal et/ou maximal de fils à l'intérieur du connecteur et/ou du câble ;
un codage du connecteur en tant que ligne de signal codée A, B, C, D ou X et/ou en tant que ligne de puissance codée A, K, L et/ou en tant que ligne de données codée A, B, D, X et Y et/ou avec LED et/ou un codage en tant que connecteur blindé ou non blindé et/ou une ligne hybride, en particulier en tant que combinaison des lignes précitées ;
une sortie de câble spécifique, de préférence d'une fiche pour une plage de 0° à 90°, de préférence de 45° à 60°, pour laquelle l'élément d'installation est adapté ;
une connexion spécifique sur les côtés respectifs pour lesquels un élément d'installation est adapté,
en particulier sous forme de connexion M8, M12, M23, RJ45, 7/8 (sept-huit), MQ15, MSUD (connecteur de vanne), connecteur Deutsch ou RJ45PP ;
un type de connecteur spécifique pour lequel l'élément d'installation est adapté, en particulier un type de connecteur du type femelle-femelle, femelle-mâle, mâle-femelle ou mâle-mâle, des pièces en H, T et Y et des répartiteurs ;
une application spécifique pour laquelle l'élément d'installation est adapté, en particulier en tant qu'interface AS, en tant que ligne Ethernet, en tant que ligne de moteur, en tant qu'application de bus de terrain ou en tant que ligne de capteur/actionneur ;
une forme de construction appropriée de l'élément d'installation en fonction de l'environnement pour lequel l'élément d'installation est adapté ;
une exigence de sécurité et/ou de redondance pour laquelle l'élément d'installation est adapté.

8. Procédé (100) selon l'une des revendications précédentes, dans lequel l'au moins une propriété de l'environnement d'installation comprend au moins l'un des éléments suivants :
une plage de température prévue comme température de l'air dans l'environnement d'installation ;
une humidité de l'air prévue dans l'environnement d'installation ;
une humidité prévue dans l'environnement d'installation ;
une tension électrique qui est prévue comme tension de service pour l'élément d'installation (10) ;
une résistance aux produits chimiques prévue dans l'environnement d'installation ;
une pression d'air prévue dans l'environnement d'installation ;
une exposition aux UV prévue dans l'environnement d'installation ;
une charge bactérienne prévue dans l'environnement d'installation ;
une charge biologique prévue dans l'environnement d'installation ;
une accélération admissible pour laquelle l'élément d'installation (10) est adapté ;
une vibration prévue dans l'environnement d'installation ;
une charge sonore prévue dans l'environnement d'installation ;
un bruit solidien prévu dans l'environnement d'installation ;
une forme de construction correspondante de l'élément d'installation en fonction du secteur d'activités pour lequel l'élément d'installation est adapté.

9. Procédé (100) selon l'une des revendications précédentes, dans lequel le test (101) de l'adéquation de l'élément d'installation (10) à l'installation dans l'environnement d'installation comprend les étapes suivantes :
Détermination de l'au moins une propriété de l'élément d'installation (10), de préférence à partir d'une base de données et/ou d'une mémoire de données, l'au moins une propriété définissant respectivement une exigence pour un paramètre de l'environnement d'installation et/ou indiquant un paramètre technique de l'élément d'installation (10) ;
Détermination de l'au moins une propriété de l'environnement d'installation, de préférence par une mesure et/ou à partir d'une base de données et/ou d'une mémoire de données, l'au moins une propriété définissant respectivement une exigence pour le paramètre technique de l'élément d'installation (10) et/ou indiquant le paramètre de l'environnement d'installation ;
Réalisation de l'évaluation de compatibilité en vérifiant l'au moins une exigence afin de déterminer, si elle est satisfaite, que l'élément d'installation (10) est adapté à l'installation dans l'environnement d'installation comme étant suffisant et, dans le cas contraire, comme étant insuffisant.

10. Procédé (100) selon l'une des revendications précédentes, dans lequel le procédé (100) comprend l'étape supplémentaire suivante :
Réception d'un identifiant (11) de l'élément d'installation (10), de préférence à partir d'un lecteur, de préférence par un scanner, afin de vérifier l'adéquation de l'élément d'installation (10) à l'environnement d'installation ;
Lecture d'au moins une propriété de l'élément d'installation (10) dans une base de données sur la base de l'identifiant reçu (11).

11. Procédé (100) selon l'une des revendications précédentes, dans lequel l'élément d'installation (10) est réalisé sous la forme d'un composant et/ou d'un câble et/ou d'un connecteur, et/ou
**caractérisé en ce que** le procédé est réalisé pour le test assisté par ordinateur de l'élément d'installation pour l'environnement d'installation lors d'une installation de composants électriques (4), disposés de manière décentralisée dans l'espace, d'une machine (1), en particulier d'une installation (1), et/ou
**en ce que** l'étape de test (101) de l'aptitude de l'élément d'installation (10) pour l'installation dans l'environnement d'installation est effectuée sur la base d'une évaluation de compatibilité d'au moins une propriété de l'élément d'installation (10) par rapport à au moins une propriété de l'environnement d'installation, en particulier une température et/ou une humidité et/ou une tension électrique et/ou une accélération.

12. Procédé selon la revendication 11, dans lequel les étapes suivantes sont effectuées lorsqu'un écart de l'au moins une propriété de l'élément d'installation (10) par rapport à l'au moins une valeur de référence et/ou limite est détecté :
Simulation d'un effet de l'écart afin de déterminer, en fonction de l'effet, l'adéquation de l'élément d'installation (10) à l'installation dans l'environnement d'installation ;
Spécification d'un autre élément d'installation (10) qui présente une plus grande adéquation pour l'utilisation dans l'environnement d'installation et/ou qui garantit une fonctionnalité de la machine (1) si l'adéquation est déterminée comme étant insuffisante ; et génération d'une sortie de l'information d'installation en fonction d'un résultat de la simulation, de préférence une liste d'éléments d'installation (10) adéquats pour l'environnement d'installation étant émise.

13. Dispositif (30) de traitement de données ayant des moyens de mise en oeuvre du procédé (100) selon l'une des revendications précédentes.

14. Programme informatique (20) comprenant des instructions qui, lorsque le programme est exécuté par un ordinateur (31), amènent l'ordinateur (31) à exécuter le procédé (100) selon l'une des revendications 1 à 12.
